# EUROPÄISCHE PATENTANMELDUNG

(11) **EP 2 634 814 A2**
(43) Veröffentlichungstag der Anmeldung: **04.09.2013**
(21) Anmeldenummer: 13157214.1
(22) Anmeldetag: 28.02.2013
(51) Int. Cl.: H01L 31/0224, H01L 31/05

(54) **Rückseitenkontaktsolarzelle**

(30) Priorität: 29.02.2012 DE 102012101665
(71) Anmelder: SCHOTT Solar AG, 55122 Mainz (DE)
(72) Erfinder: Meyer, Christine, 60326 Frankfurt (DE); Roth, Peter, 63450 Hanau (DE); Moschner, Jens, 63755 Alzenau (DE); Reime, Sascha, 63477 Maintal (DE); Ramspeck, Klaus, 63450 Hanau (DE)
(74) Vertreter: Stoffregen, Hans-Herbert

(57) **Zusammenfassung**

Die Erfindung bezieht sich auf eine Rückseitenkontaktsolarzelle, umfassend ein Halbleitersubstrat mit einer Frontseite (10) und einer Rückseite, von der Frontseite zu der Rückseite sich erstreckende Durchgangsöffnungen (14) mit elektrisch leitenden Durchkontaktierungen, frontseitig verlaufende linienförmige elektrisch leitende erste Verbinder (16, 18) und erste Verbinder elektrisch leitend verbindende und quer zu den ersten Verbindern verlaufende elektrisch leitende zweite Verbinder (20, 22, 24, 26, 28, 30 32, 34), die mit den Durchkontaktierungen elektrisch leitend verbunden sind. Damit die Frontseitenmetallisierung der Solarzelle eine geringe Abschattung bietet, einen geringen Serienwiderstand aufweist und bei Aufbringen der Kontaktierung mittels Siebdruck eine gute Druckbarkeit bei gutem Druckbild ermöglicht, ist vorgesehen, dass mit zumindest einigen der Durchkontaktierungen zumindest drei zweite Verbinder (20, 22, 24, 26, 28, 30 32, 34) elektrisch leitend verbunden sind, von denen zumindest zwei zweite Verbinder (20, 22, 24, 26, 28, 30 32, 34) erste Verbinder (16, 18) unter einem Winkel α mit 30 ° ≤ α ≤ 60° schneiden.

## Beschreibung

Die Erfindung bezieht sich auf eine Rückseitenkontaktsolarzelle, umfassend ein Halbleitersubstrat mit einer Frontseite und einer Rückseite, von der Frontseite zu der Rückseite sich erstreckende Durchgangsöffnungen mit elektrisch leitenden Durchkontaktierungen, frontseitig verlaufende linienförmige elektrisch leitende erste Verbinder und erste Verbinder elektrisch leitend verbindende und quer zu den ersten Verbindern verlaufende elektrisch leitende zweite Verbinder, die mit den Durchkontaktierungen elektrisch leitend verbunden sind.

Der Wirkungsgrad einer Solarzelle hängt u. a. von der für die auftreffende Strahlung unbedeckten Frontfläche oder -seite ab. Da die Frontseitenkontakte jedoch die wirksame Fläche beschränkten, sind Rückseitenkontaktsolarzellen entwickelt worden, zu denen die MWT (Metal Wrap Through)-Zellen gehören. Bei MWT-Zellen wird eine frontseitige Metallisierung über Durchgangsöffnungen durchsetzende Durchkontaktierungen zur Rückseite geführt, die - elektrisch isoliert vom Rückseitenkontakt - über sogenannte Busbars auf der Rückseite verbunden werden. Zur Optimierung sollte des Weiteren die Metallisierung, d. h. das Frontseitenkontaktmuster einen geringen Serienwiderstand, eine gute Druckbarkeit bzw. ein gutes Druckbild der auch als Finger zu bezeichnenden ersten Verbinder aufweisen.

Ferner sollte die Anzahl der Durchkontaktierungen gering sein, um Kurzschlüsse zwischen den Bereichen des Halbleitersubstrats unterschiedlicher Leitfähigkeitstypen zu vermeiden, also bei einem p-Silicium-basierten Halbleitersubstrat zwischen dem frontseitigen Emitterbereich und der Basis.

Bei Rückseitenkontaktsolarzellen bilden die ersten Verbinder üblicherweise ein strahlenförmiges bzw. radiales Muster, wobei aus unterschiedlichen Richtungen gerundete oder gekrümmte Linien in den Durchkontaktierungen münden. Die Finger oder Linien werden üblicherweise im Siebdruckverfahren aufgebracht. Dabei stellt sich heraus, dass die Linien, die senkrecht zur Vorzugsdruckrichtung aufgebracht werden, insbesondere gekrümmte oder gerundete Linien, nicht so dünn druckbar sind wie Linien in Vorzugsdruckrichtung. Vorzugsdruckrichtung ist dabei die Richtung, entlang der ein Rakel über ein Sieb geführt wird, durch das üblicherweise Pastenmaterial zur Bildung der Finger hindurchgedrückt wird.

Typische Muster einer Frontseitenmetallisierung einer MWT-Zelle sind der WO-A-00/31803 zu entnehmen.

Die WO-A-10/097268 schlägt eine MWT-Solarzelle vor, bei der die die ersten Verbinder bildenden Finger parallel zueinander verlaufen und ihrerseits über senkrecht sich hierzu erstreckende zweite Verbinder mit den Durchkontaktierungen erlektrisch leitend verbunden werden. Die Anzahl der Durchgangsöffnungen mit den Durchkontaktierungen, die auch als Vias bezeichnet werden, beträgt nach dieser Veröffentlichung üblicherweise 60 - 80 bei 60 - 80 parallelen Fingern pro Zelle. Aufgrund der Vielzahl der Vias sind aufwendige prozesstechnische Maßnahmen zu treffen, um Kurzschlüsse zwischen Emitter und Basis zu vermeiden.

Der vorliegenden Erfindung liegt die Aufgabe zugrunde, eine Rückseitenkontaktsolarzelle der eingangs genannten Art so weiterzubilden, dass eine Frontseitenmetallisierung zur Bildung des Frontseitenkontakts zur Verfügung gestellt wird, die eine geringe Abschattung bietet, einen geringen Serienwiderstand aufweist und bei Aufbringen der Kontaktierung mittels Siebdruck eine gute Druckbarkeit bei gutem Druckbild ermöglicht.

Zur Lösung der Aufgabe sieht die Erfindung im Wesentlichen vor, dass mit zumindest einigen der Durchkontaktierungen zumindest drei zweite Verbinder elektrisch leitend verbunden sind, von denen zumindest zwei zweite Verbinder die ersten Verbinder unter einem Winkel zwischen 30° und 60° schneiden sollten. Mit den zweiten Verbindern wird sodann der von den ersten Verbindern gesammelte Strom den Durchkontaktierungen zugeführt.

Insbesondere ist jedoch vorgesehen, dass mit zumindest einigen der Durchkontaktierungen zumindest vier zweite Verbinder verbunden sind, wobei jeweils zwei zweite Verbinder entlang einer ersten oder einer zweiten Gerade verlaufen, die sich im Bereich der Durchgangskontaktierung schneiden. Dabei sollte die erste und zweite Gerade symmetrisch zu einer dritten Geraden verlaufen, die die ersten Verbinder senkrecht oder in etwa senkrecht schneidet.

Vorrangig wird die Frontseitenmetallisierung über parallel zueinander verlaufende linienförmige erste Verbinder gebildet, die weitgehend im konstanten Abstand zueinander verlaufen. Parallele Linien verbessern die Güte des Drucks. Durch die Verbindung der zu den ersten Verbindern grundsätzlich schräg verlaufenden zweiten Verbinder, die auch als Querverbinder bezeichnet werden können und zu den Durchkontaktierungen führen, wird die Länge der ersten Verbinder minimiert und der Gesamtstromwert reduziert mit der Folge, dass die ersten Verbinder mit sehr kleinem Querschnitt q bzw. geringer Breite B ausgeführt werden können, so dass Abschattung und Materialverbrauch minimiert werden. Dabei sollten die ersten Verbinder des Weiteren in Vorzugsdruckrichtung bei einem Auftrag mittels Siebdruck verlaufen, so dass eine gute Druckbarkeit und somit Reproduzierbarkeit gegeben ist.

In Weiterbildung der Erfindung ist vorgesehen, dass entlang zumindest einiger der entlang der ersten und/oder der zweiten Gerade verlaufenden zweiten Verbinder weitere zweite Verbinder verlaufen, wobei insbesondere der Abstand zwischen den benachbart und parallel zueinander verlaufenden zweiten Verbindern gleich oder in etwa gleich dem der ersten Verbinder sein kann. Bei einer entsprechenden Geometrie der zweiten Verbinder können diese jeweils einen Querschnitt aufweisen, der dem des ersten Verbinders entspricht.

Des Weiteren sollten die ersten Verbinder zwischen den benachbart und parallel zueinander verlaufenden zweiten Verbindern unterbrochen sein, also Zwischenraum zwischen den zweiten Verbindern frei von ersten Verbindern bzw. Abschnitten dieser sein, so dass die schräg zu den ersten Verbindern verlaufenden zweiten Verbinder als Stromsammler dienen und nicht nur als Stromableiter, die den Stromtransport zur Durchkontaktierung gewährleisten.

Verlaufen zweite Verbinder benachbart und parallel zueinander mit einem Abstand, der erwähntermaßen vorzugsweise dem Abstand benachbarter erster Verbinder entsprechen kann, können erwähntermaßen sehr schmale zweite Verbinder aufgetragen werden, so dass die Abschattung bei gleichem effektiven Widerstand verringert wird.

In Weiterbildung können auch sogenannte Redundanzverbinder aufgebracht werden, die sich abschnittsweise parallel entlang von zweiten Verbindern erstrecken und jeweils mit einer Durchkontaktierung verbunden sind.

Ist vorzugsweise die Breite der zweiten Verbinder gleich der der ersten Verbinder, so können selbstverständlich auch breitere Verbinder verwendet werden oder Verbinder, die in unterschiedlichen Bereichen unterschiedliche Breiten aufweisen.

Um bei geringem Übergangswiderstand die zweiten Verbinder mit den Durchkontaktierungen elektrisch leitend zu verbinden, ist in Weiterbildung der Erfindung vorgesehen, dass die zweiten Verbinder in einem elektrisch leitenden kreisförmigen oder ovalen Kontaktbereich münden, der die Durchgangsöffnung, die von der Durchkontaktierung durchsetzt ist, umgibt, wobei der Kontaktbereich gegebenenfalls Abschnitte der Durchkontaktierung ist.

Der Kontaktbereich kann auch mit den ersten und zweiten Verbindern auf die Frontseite aufgebracht werden, wobei die elektrisch leitende Verbindung mit der zuvor in die Durchgangsöffnung eingebrachten Durchkontaktierung hergestellt wird.

Entsprechend dem Stand der Technik sollte die Solarzelle ein Muster von Einheitszellen aufweisen, wobei jede Einheitszelle mittig oder in etwa mittig eine der Durchgangsöffnungen aufweist. Dabei sollte die Anzahl der Einheitszellen X x X oder Y x Z mit Y ≠ Z betragen, wobei bevorzugterweise 3 ≤ X, Y, Z ≤ 5 ist.

Die ersten Verbinder erstrecken sich üblicherweise über mehrere Einheitszellen. Gleiches kann, muss jedoch nicht für die zweiten Verbinder gelten. Es besteht auch die Möglichkeit, dass die zweiten Verbinder sich nicht vollständig in Länge und oder Breite der Einheitszelle erstrecken. Insbesondere dann, wenn mehrere zweite Verbinder benachbart parallel zueinander verlaufen, müssen sich die entlang einer gemeinsamen Gerade verlaufenden zweiten Verbinder nicht über die gesamte Länge oder Breite der Einheitszelle erstrecken.

Das erfindungsgemäß vorgesehene Kontaktierungsmuster ist nicht nur auf Frontseiten beschränkt, sondern kann auch auf der Rückseite einer Bifacial Solarzelle angewendet werden. Auch auf einen bestimmten Solarzellentyp erfolgt eine Beschränkung nicht. Das Halbleitersubstrat kann eine n- oder p-Basis aufweisen. Eine Benutzung bei Dünnschichtsolarzellen ist gleichfalls möglich.

Die ersten und zweiten Verbinder bestehen aus einem leitfähigen Material und werden typischerweise aus einer Silberpaste hergestellt. Andere geeignete Materialien können alternativ oder ergänzend benutzt werden. Beispielhaft sind Nickel und/oder Zinn zu nennen.

Werden vorzugsweise die Finger durch Siebdruck aufgebracht, so sind andere Verfahren wie Plating gleichfalls möglich.

Weitere Einzelheiten, Vorteile und Merkmale der Erfindung ergeben sich nicht nur aus den Ansprüchen, den diesen zu entnehmenden Merkmalen - für sich und/oder in Kombination -, sondern auch aus der nachfolgenden Beschreibung von der Zeichnung zu entnehmenden bevorzugten Ausführungsbeispielen.

Es zeigen:
- Fig. 1: eine Draufsicht auf eine Rückseitenkontaktsolarzelle,
- Fig. 2: einen Ausschnitt A der Fig. 1,
- Fig. 3: einen Ausschnitt B der Fig. 2,
- Fig. 4: einen Ausschnitt C der Fig. 3 und
- Fig. 5: eine Prinzipdarstellung einer weiteren Ausführungsform einer Mustereinheitszelle einer Rückseitenkontaktsolarzelle.

In den Figuren sind Ausschnitte einer Rückseitenkontaktsolarzelle dargestellt, deren Frontseitenmetallisierung ein Muster aufweist, das eine Optimierung in Bezug auf geringe Abschattung, geringen Widerstand und im Falle des Auftragens mittels Siebdruck hinsichtlich Druckbarkeit und Druckbild bietet.

Bei der Rückseitenkontaktsolarzelle handelt es sich um eine MWT (Metal Wrap Through) -Solarzelle bekannten Aufbaus. Somit kann die Solarzelle aus einem p-Silizium-basierten Halbleitersubstrat als Basis mit frontseitigem n-leitenden Emitter bestehen. Rückseitig weist das Substrat üblicherweise eine Aluminiumschicht zur Bildung einerseits eine Rückseitenkontakts und andererseits eines Backsurfacefields (BSF) auf. Die Erfindung ist jedoch gleichermaßen auf ein Halbleitersubstrat aus n-Material mit rückseitigem Emitter und frontseitigem Frontsurfacefield (SFF) anwendbar. Auch eine Verwendung für Dünnschichtsolarzellen kommt in Frage.

Unabhängig hiervon ist von den zum Einsatz gelangenden Materialien bzw. Halbleitertyps erfindungsgemäß die mit Strahlung beaufschlagte Fläche mit einer Metallisierung zur Bildung eines Kontaktmusters zu versehen, um bei geringer Abschattung und geringem Serienwiderstand im hinreichenden Umfang Strom abzuleiten und im Ausführungsbeispiel über in Durchgangsöffnungen vorhandenem Durchkontaktierungsmaterial zur Rückseite zu leiten. Rückseitig sind die Durchkontaktierungen gegenüber dem Rückseitenkontakt isoliert, jedoch untereinander typischerweise über Busbars verbunden. Auch insoweit wird auf den hinreichend bekannten Stand der Technik verwiesen.

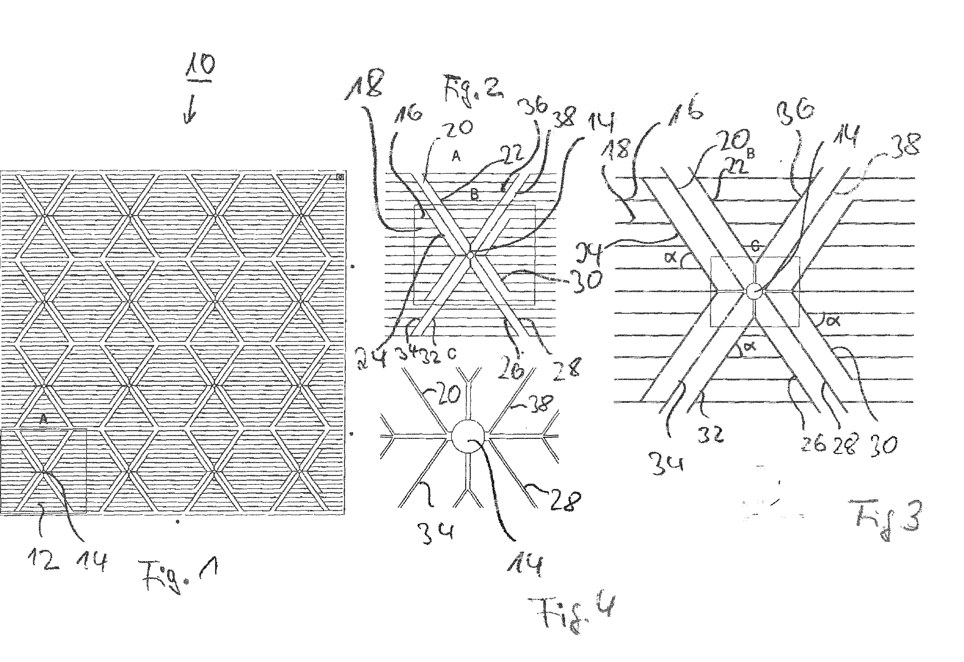

In Fig. 1 ist rein beispielhaft in Draufsicht eine Frontseite 10 einer Rückseitenkontaktsolarzelle (MWT-Solarzelle) dargestellt. Diese besteht aus einem Muster von Einheitszellen 12, von denen eine in vergrößerter Darstellung in Fig. 2 dargestellt ist.

Die Frontseite 10 der Solarzelle weist in gewohnter Weise Durchgangsöffnungen 14 auf, die zum Ausbilden des Frontseitenkontakts von einem elektrisch leitenden Kontaktmaterial durchsetzt sind, um die erforderliche Durchkontaktierung von der Frontseite 10 zur Rückseite sicherzustellen, wie dies zuvor erläutert worden ist. Die Durchgangsöffnungen 14 mit dem in diese eingebrachten elektrisch leitenden Material werden als Durchkontaktierungen bezeichnet.

Um den Strom zu den Durchkontaktierungen ableiten zu können, wird dieser zunächst über parallel zueinander verlaufende linienförmige erste Verbinder 16, 18 gesammelt. Die ersten Verbinder 16, 18 können auch als Finger bezeichnet werden. Die Finger erstrecken sich parallel zueinander in Vorzugsdruckrichtung, sofern die Finger mittels Siebdruck aufgebracht werden.

Die Vorzugsrichtung wird durch die Bewegung eines Rakels entlang eines Siebes vorgegeben, durch das das die Finger 16, 18 bildende Pastenmaterial wie Silberpaste hindurchgedrückt wird.

Die ersten Verbinder 16, 18 - nachstehend als Finger 16, 18 bezeichnet - gehen in zweite Verbinder über, über die der Strom zu den Durchkontaktierungen abgeleitet wird.

Wie sich aus der zeichnerischen Darstellung ergibt, gehen von jeder Durchgangsöffnung 14 und damit Durchkontaktierung strahlenförmig mehrere parallel zueinander verlaufende zweite linienförmige Verbinder aus. Diese sind in der Fig. 2 mit den Bezugszeichen 20, 22, 24; 26, 28, 30; 32, 34; 36, 38 gekennzeichnet. Die zweiten Verbinder 20, 22, 24, 26, 28, 30, 32, 34, 36, 38 schließen zu den parallel zueinander verlaufenden Fingern 16, 18, einen Winkel α zwischen 30° und 60° ein.

Des Weiteren verdeutlichen die Figuren, dass die strahlenförmig von der jeweiligen Durchgangsöffnung 14 ausgehenden zweiten Verbinder 20, 22, 24, 26, 28, 30, 32, 34, 36, 38 derart zueinander ausgerichtet sind, dass diese diametral gegenüberliegend zur Durchgangsöffnung 14 jeweils entlang bzw. parallel zu einer Geraden verlaufen, die die Durchgangsöffnung 24 durchsetzt. So laufen die zweiten Verbinder 20, 22, 24 und 26, 28, 30 entlang einer ersten Geraden und die verbleibenden zweiten Verbinder 32, 34 und 36, 38 entlang einer zweiten Geraden. Die Geraden selbst sind wiederum symmetrisch zu einer nicht eingezeichneten dritten Geraden angeordnet, die die Finger 16, 18 senkrecht oder im Wesentlichen senkrecht schneidet.

Aus der Zeichnung ergibt sich des Weiteren, dass die ersten Finger 16, 18 nicht mehrere zweite Verbinder schneiden, sondern durch diese unterbrochen sind. Das heißt, dass der Zwischenraum zwischen benachbart und parallel zueinander verlaufenden zweiten Verbindern frei von Fingern bzw. Abschnitten dieser ist. Dies ergibt sich aus den in den zwischen den Verbindern 20, 22, 24 bzw. 32, 34 bzw. 26, 28, 30 bzw. 36, 38 vorhandenen Freiräumen.

Neben den im Wesentlichen über ihre gesamte Länge parallel zueinander verlaufenden zweiten zweiten Verbindern 20, 22 bzw. 36, 38 bzw. 32, 34 bzw. 26, 28 können des Weiteren von den Durchkontaktierungen ausgehend zweite Verbinder in Form von Redundanzverbindungen gedruckt sein, die beispielhaft mit dem Bezugszeichen 24 bzw. 30 gekennzeichnet sind.

Der Abstand zwischen den benachbart und parallel zueinander verlaufenden linienförmigen Verbindern, also der Abstand zwischen den Verbindern 24, 20 bzw. 20, 22 bzw. 36, 38 bzw. 26, 28 bzw. 28, 30 bzw. 32, 34 sollte gleich dem Abstand zwischen benachbarten Fingern 16 und 18 sein, ohne dass hierdurch die erfindungsgemäße Lehre eingeschränkt wird.

Wie die Darstellung der Fig. 1 verdeutlicht, bilden die zweiten Verbinder eine Art Rhombenmuster, wobei sich entlang in einer ersten Reihe angeordneten Durchgangsöffnungen 14 im Wesentlichen geschlossene Rhomben und in einer senkrecht hierzu verlaufenden Reihe offene Rhomben ergeben. Im Ausführungsbeispiel sind die in der Zeichnung vertikal verlaufenden Rhomben geschlossen und die horizontal verlaufenden Rhomben offen.

Um eine hinreichende elektrisch leitende Verbindung mit geringen Übergangswiderständen zwischen den zweiten Verbindern 20, 22, 24, 26, 28, 30, 32, 34, 36, 38 und den Durchkontaktierungen sicherzustellen, können die Durchgangsöffnungen 14 von einem kreis- oder ovalförmigen Kontaktbereich umgeben sein, der elektrisch leitend mit der Durchkontaktierung verbunden ist. Der entsprechende Kontaktbereich kann zusammen mit den ersten und zweiten Verbindern auf die Frontseite der Solarzelle z. B. im Siebdruckverfahren aufgebracht werden.

Aufgrund des erfindungsgemäßen Kontaktmusters ist im Vergleich zu bekannten Frontseitenmetallisierungen eine geringe Abschattung gegeben. Auch sind die Finger 16, 18 überaus fein und reproduzierbar ausbildbar, da diese in Vorzugsdruckrichtung beim Siebdruck verlaufen.

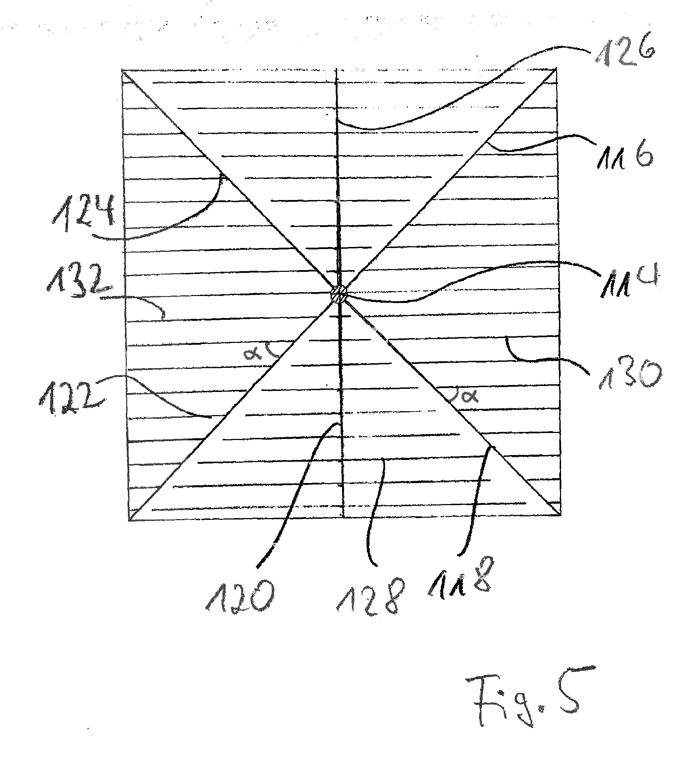

In der Fig. 5 ist eine Variante eines Kontaktmusters einer Rückseitenkontaktsolarzelle dargestellt, und zwar ein Ausschnitt, der eine Einheitszelle entsprechend der Fig. 2 wiedergibt. Man erkennt, dass von einer Durchgangsöffnung bzw. Durchkontaktierung 114 strahlenförmig zweite Verbinder 116, 118, 120, 122, 124, 126 ausgehen, die ggf. ineinander übergehen. Die als die Finger bezeichneten ersten Verbinder 128, 130, 132 verlaufen senkrecht zu dem in der Zeichnung vertikal verlaufenden zweiten Verbinder 120 und geneigt zu den verbleibenden zweiten Verbindern 116, 118, 122, 124. Des Weiteren enden die über die vertikal verlaufenden zweiten Verbinder 122, 126 elektrisch leitend verbundenen Finger 128 beabstandet zu den schräg zu diesen verlaufenden zweiten Verbindern 118, 122, 116, 124. Die ausschließlich zwischen den schräg verlaufenden zweiten Verbindern 116, 118 bzw. 122, 124 verlaufenden Finger 130, 132 sind mit ersteren elektrisch leitend verbunden.

Die in der Fig. 5 dargestellte Außenumrandung stellt keinen Verbinder dar, sondern soll vielmehr die Begrenzung der Einheitszelle andeuten.

## Patentansprüche

1. Rückseitenkontaktsolarzelle, umfassend
- ein Halbleitersubstrat mit einer Frontseite (10) und einer Rückseite,
- von der Frontseite zu der Rückseite sich erstreckende Durchgangsöffnungen (14) mit elektrisch leitenden Durchkontaktierungen (114),
- frontseitig verlaufende linienförmige elektrisch leitende erste Verbinder (16, 18, 128, 130, 132) und
- erste Verbinder elektrisch leitend verbindende und quer zu den ersten Verbindern verlaufende elektrisch leitende zweite Verbinder (20, 22, 24, 26, 28, 30 32, 34, 116, 118, 120, 122, 124, 126), die mit den Durchkontaktierungen elektrisch leitend verbunden sind,
**dadurch gekennzeichnet,**
**dass** mit zumindest einigen der Durchkontaktierungen (114) zumindest drei zweite Verbinder (20, 22, 24, 26, 28, 30 32, 34, 116, 118, 120, 122, 124, 126) elektrisch leitend verbunden sind, von denen zumindest zwei zweite Verbinder (20, 22, 24, 26, 28, 30 32, 34, 116, 118, 120, 122, 124, 126) erste Verbinder (16, 18, 128, 130, 132) unter einem Winkel α mit 30 ° ≤ α ≤ 60° schneiden.

2. Rückseitenkontaktsolarzelle nach Anspruch 1,
**dadurch gekennzeichnet,**
**dass** mit zumindest einigen der Durchkontaktierungen zumindest vier zweite Verbinder (20, 28, 34, 38) verbunden sind, wobei jeweils zwei zweite Verbinder (20, 28; 34, 38) entlang einer ersten oder einer zweiten Gerade verlaufen, die sich im Bereich der Durchgangskontaktierung schneiden.

3. Rückseitenkontaktsolarzelle nach Anspruch 1 oder 2,
**dadurch gekennzeichnet,**
**dass** die erste und die zweite Gerade symmetrisch zu einer dritten Gerade verlaufen, die die ersten Verbinder (16, 18, 128, 130, 132) senkrecht oder in etwa senkrecht schneidet.

4. Rückseitenkontaktsolarzelle nach zumindest einem der vorherigen Ansprüche, **dadurch gekennzeichnet,**
**dass** entlang der dritten Gerade ein fünfter und ein sechster zweiter Verbinder (120, 126) verläuft.

5. Rückseitenkontaktsolarzelle nach zumindest einem der vorherigen Ansprüche, **dadurch gekennzeichnet,**
**dass** zumindest einige, vorzugsweise sämtliche, der mit dem fünften und sechsten zweiten Verbinder (120, 126) elektrisch leitend verbundenen ersten Verbinder (128) beabstandet zu den entlang der ersten und zweiten Gerade verlaufenden zweiten Verbindern (116, 118, 122, 124) enden.

6. Rückseitenkontaktsolarzelle nach zumindest einem der vorherigen Ansprüche.
**dadurch gekennzeichnet,**
**dass** parallel zu zumindest einem, vorzugsweise zu jedem entlang der ersten und/oder der zweiten Gerade verlaufenden zweiten Verbindern (20, 28, 34, 38) zumindest ein weiterer zweiter Verbinder (22, 26, 32, 36) verläuft.

7. Rückseitenkontaktsolarzelle nach zumindest einem der vorherigen Ansprüche, **dadurch gekennzeichnet,**
**dass** die zweiten Verbinder (20, 22, 24, 26, 28, 30 32, 34, 116, 118, 120, 122, 124, 126) strahlenförmig vom Bereich der Durchgangskontaktierung (114) ausgehen.

8. Rückseitenkontaktsolarzelle nach zumindest einem der vorherigen Ansprüche,
**dadurch gekennzeichnet,**
**dass** Zwischenraum zwischen zwei benachbarten parallel zueinander verlaufenden zweiten Verbindern (20, 22, 24, 26, 28, 30 32, 34, 116, 118, 120, 122, 124, 126) frei von ersten Verbindern (16, 18, 128, 130, 132) bzw. Abschnitten dieser ist.

9. Rückseitenkontaktsolarzelle nach zumindest einem der vorherigen Ansprüche,
**dadurch gekennzeichnet,**
**dass** der Abstand von benachbart und parallel zueinander verlaufenden zweiten Verbindern (20, 22, 24, 26, 28, 30 32, 34, 116, 118, 120, 122, 124, 126) gleich oder in etwa gleich Abstand von zwei benachbart zueinander verlaufenden ersten Verbindern (16, 18, 128, 130, 132) ist.

10. Rückseitenkontaktsolarzelle nach zumindest einem der vorherigen Ansprüche,
**dadurch gekennzeichnet,**
**dass** jeweilige Breite von benachbart und parallel zueinander verlaufenden zweiten Verbindern (20, 22, 24, 26, 28, 30 32, 34, 116, 118, 120, 122, 124, 126) gleiche oder in etwa gleiche Breite des ersten Verbinders (16, 18, 128, 130, 132) ist.

11. Rückseitenkontaktsolarzelle nach zumindest einem der vorherigen Ansprüche,
**dadurch gekennzeichnet,**
**dass** die zweiten Verbinder (20, 22, 24, 26, 28, 30 32, 34, 116, 118, 120, 122, 124, 126) in einem elektrisch leitenden kreisförmigen oder ovalen Kontaktbereich münden, der die Durchgangsöffnung (14) umgibt, wobei der Kontaktbereich gegebenenfalls Abschnitt der Durchgangskontaktierung (114) ist.

12. Rückseitenkontaktsolarzelle nach zumindest einem der vorherigen Ansprüche,
**dadurch gekennzeichnet,**
**dass** entlang einer gemeinsamen Geraden verlaufende zweite Verbinder (20, 22, 24; 26, 28, 30 / 32, 34; 36, 38) sich diametral zu der von der Geraden geschnittenen Durchgangsöffnung (14) erstrecken.

13. Solarzelle, vorzugsweise Rückseitenkontaktzelle nach zumindest einem der vorhergehenden Ansprüche, wobei die Solarzelle ein Muster von Einheitszellen (12) ist und jede Einheitszelle mittig eine der Durchgangsöffnungen (14) mit der Durchkontaktierung (114) aufweist,
**dadurch gekennzeichnet,**
**dass** die Solarzelle X x X oder X x Y mit X ≠ Y Einheitszellen mit insbesondere 3 ≤ X, Y, Z ≤ 5 aufweist.
